# EUROPEAN PATENT APPLICATION

(11) **EP 3 672 057 A1**
(43) Date of publication of application: **24.06.2020**
(21) Application number: 18860831.9
(22) Date of filing: 22.08.2018
(51) Int. Cl.: H02N 11/00, H01L 41/047, H01L 41/083, H01L 41/09, H01L 41/277, H01L 41/293, H01L 41/297

(54) **PIEZOELECTRIC ELEMENT FORMED FROM ELASTOMER AND METHOD FOR PRODUCING PIEZOELECTRIC ELEMENT FORMED FROM ELASTOMER**

(30) Priority: 28.09.2017 JP 2017188729
(71) Applicant: Toyoda Gosei Co., Ltd., Kiyosu-shi, Aichi 452-8564 (JP)
(72) Inventor: KUMEGAWA, Shohei, Kiyosu-shi, Aichi 452-8564 (JP); SAGO, Genki, Kiyosu-shi, Aichi 452-8564 (JP); MATSUNAGA, Naoto, Kiyosu-shi, Aichi 452-8564 (JP)
(74) Representative: Kramer Barske Schmidtchen Patentanwälte PartG mbB
(86) International application number: PCT/JP2018/031037
(87) International publication number: WO 2019/065010

(57) **Abstract**

An elastomer piezoelectric element (10) is configured by alternately disposing first opposite electrodes (11a) and second opposite electrodes (11b), and sandwiching a dielectric layer (12) between each first opposite electrode (11a) and the corresponding second opposite electrode (11b). Each of the dielectric layers (12) includes a dielectric elastomer sheet-shaped dielectric portion (13) and a conductive elastomer first common electrode (15a) connecting the first opposite electrodes (11a) to each other or a conductive elastomer second common electrode (15b) connecting the second opposite electrodes (11b) to each other. The first common electrode (15a) and the second common electrode (15b) are provided so as to extend from one main surface to another main surface of the dielectric portion (13), and are joined to the first opposite electrode (11a) and the second opposite electrode (11b), respectively, on a joint surface (S) along the dielectric layer (12).

## Description

### TECHNICAL FIELD

The present invention relates to an elastomer piezoelectric element, and a method for producing an elastomer piezoelectric element.

### BACKGROUND

As is disclosed in Patent Document 1 and Patent Document 2, an elastomer piezoelectric element configured by alternately disposing first opposite electrodes and second opposite electrodes, and sandwiching an elastomer dielectric layer between each first opposite electrode and the corresponding second opposite electrode is known.

### Prior Art Documents

### Patent Documents

Patent Document 1: Japanese Laid-Open Patent Publication No. 2012-125140
Patent Document 2: Japanese National Phase Laid-Open Patent Publication No. 2016-509826

### SUMMARY OF THE INVENTION

### Problems that the Invention is to Solve

The above-described elastomer piezoelectric element is provided with an external contact for applying identical electric potentials to all of the first opposite electrodes, and an external contact for applying identical electric potentials to all of the second opposite electrodes. The external contact corresponding to the first opposite electrodes is formed, for example, by providing the first opposite electrodes and the dielectric layers with through-holes, exposing the edges of all of the first opposite electrodes, and providing a common electrode for connecting the exposed edges of all of the first opposite electrodes to each other. The same applies to the external contact corresponding to the second opposite electrode.

When the external contacts of the above-described structure are employed, the first opposite electrodes and the second opposite electrodes are joined to the common electrodes at the edges (end faces) of the first opposite electrodes and the second opposite electrodes. In this case, the joint area between the opposite electrode and the common electrode is very small. Therefore, there is a problem in that, when the dielectric portion is displaced to a large extent or the dielectric portion is repeatedly displaced, a joint portion between the opposite electrode and the common electrode tends to be broken.

It is an objective of the present invention to improve the durability of an elastomer piezoelectric element.

### Means for Solving the Problems

To achieve the foregoing objective, an elastomer piezoelectric element is provided that is configured by alternately disposing first opposite electrodes and second opposite electrodes, and sandwiching a dielectric layer between each first opposite electrode and the corresponding second opposite electrode. Each of the dielectric layers includes a dielectric elastomer sheet-shaped dielectric portion and a conductive elastomer common electrode connecting the first opposite electrodes to each other or connecting the second opposite electrodes to each other. The common electrode is provided so as to extend from one main surface to another main surface of the dielectric portion, and is joined to the first opposite electrode or the second opposite electrode on a joint surface along the dielectric layer.

This configuration provides, as a portion of the dielectric layer, a common electrode electrically connecting the first opposite electrodes to each other or electrically connecting the second opposite electrodes to each other. In this case, a joint surface of the opposite electrode and the common electrode is located between the dielectric layer and the opposite electrode. This ensures a broader joint surface than that in the case where the common electrode is joined to the edge (end face) of the opposite electrode. As a result of this, the opposite electrode and the common electrode are tightly joined together to improve the durability of the elastomer piezoelectric element against displacement of the dielectric layer.

In the above-described elastomer piezoelectric element, the common electrode is preferably provided in an interior of a through-hole provided in the dielectric portion.

This configuration covers a joint portion of the opposite electrode and the common electrode with the dielectric portion made of dielectric elastomer. Thus, when external force is exerted on the elastomer piezoelectric element, it is difficult for the impact of the external force to travel through the above-described joint portion. As a result of this, the durability of an elastomer piezoelectric element is improved.

In the above-described elastomer piezoelectric element, the common electrode is preferably provided at an edge of the dielectric portion.

This above-described configuration exposes the common electrode at the periphery of the dielectric layer, that is, at the periphery of the elastomer piezoelectric element. Therefore, external contacts can be located at the periphery of the elastomer piezoelectric element. This simplifies the external configuration for applying electric potentials to the elastomer piezoelectric element.

In the above-described elastomer piezoelectric element, the common electrode is preferably a protrusion formed by protruding a portion of the conductive elastomer first opposite electrode or the conductive elastomer second opposite electrode in a thickness direction of the dielectric portion.

This configuration reduces the joint portion between the opposite electrode and the common electrode.

In the above-described elastomer piezoelectric element, an insulating elastomer insulated portion is preferably disposed on a portion that is located between two of the dielectric layers and on which neither the first opposite electrode nor the second opposite electrode is disposed.

This configuration provides the insulated portion, so that an air layer tends not to be formed in an area surrounding the opposite electrode between two dielectric layers. This prevents creeping discharge from being caused by formation of an air layer, and prevents dielectric breakdown from occurring due to creeping discharge.

To achieve the foregoing objective, a method for producing an elastomer piezoelectric element is provided that includes: a unit layer forming step of forming a unit layer that includes a dielectric elastomer sheet-shaped dielectric portion, two conductive elastomer common electrodes extending from one main surface to another main surface of the dielectric portion, and an opposite electrode disposed on one of the main surfaces of the dielectric portion and connected to one of the two common electrodes; and a stacking step of stacking and joining a plurality of the unit layers together. In the stacking step, a portion in which the common electrode and the opposite electrode are joined together and a portion in which the common electrodes are joined to each other are formed, so that specific ones of the opposite electrodes are connected to each other.

To achieve the foregoing objective, a method for producing an elastomer piezoelectric element is provided that includes: stacking dielectric elastomer sheet-shaped dielectric portions and opposite electrodes alternately by repeatedly performing a dielectric portion forming step of forming the dielectric portion and an electrode forming step of forming two conductive elastomer common electrodes extending from one main surface to another main surface of the dielectric portion, and forming, on one of the main surfaces of the dielectric portion, an opposite electrode connected to one of the two common electrodes; and connecting specific ones of the opposite electrodes to each other by, when newly forming two of the common electrodes in the electrode forming step, forming a portion in which the new common electrode and the opposite electrode located at an underlying layer are joined together and a portion in which the new common electrode and the common electrode located at an underlying layer are joined together.

These the production methods provide an elastomer piezoelectric element including a common electrode connected to an opposite electrode on a broad joint surface.

### EFFECTS OF THE INVENTION

The present invention improves the durability of an elastomer piezoelectric element.

### BRIEF DESCRIPTION OF THE DRAWINGS

Fig. 1 is a cross-sectional view showing the schematic configuration of an elastomer piezoelectric element.
Fig. 2 shows a first method for producing an elastomer piezoelectric element.
Fig. 3 shows a second method for producing an elastomer piezoelectric element.
Fig. 4 is a cross-sectional view showing the schematic configuration of a modification of the elastomer piezoelectric element.
Fig. 5 shows a modification of the method for producing the elastomer piezoelectric element.
Fig. 6 shows a modification of the method for forming the common electrode.

### MODES FOR CARRYING OUT THE INVENTION

An elastomer piezoelectric element according to an embodiment will be described below.

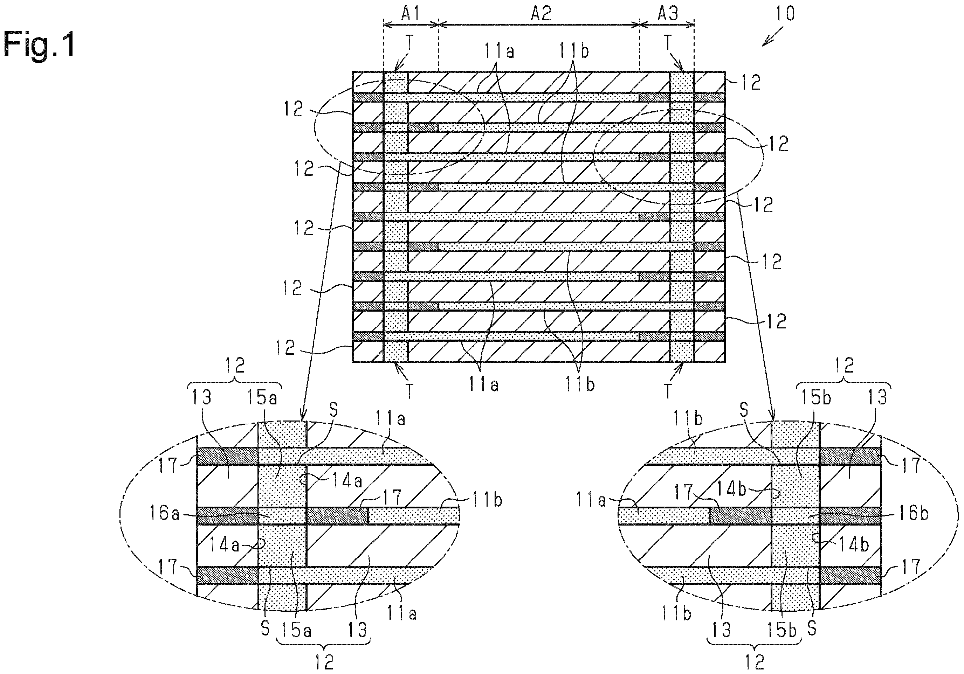

As shown in Fig. 1, an elastomer piezoelectric element 10 is a multi-layered structure configured by alternately disposing first opposite electrodes 11a and second opposite electrodes 11b, and sandwiching a dielectric layer 12 between each first opposite electrode 11a and the corresponding second opposite electrode 11b.

The first opposite electrodes 11a and the second opposite electrodes 11b are formed in the form of, for example, a thin film having a thickness of 0.1 to 100 µm. Between two of the dielectric layers 12, the first opposite electrode 11a is disposed while being displaced in one direction (in Fig. 1, the direction toward the left side) in relation to the centers of the dielectric layers 12. The second opposite electrode 11b is disposed while being displaced in the direction opposite to the first opposite electrode 11a (in Fig. 1, the direction toward the right side) in relation to the centers of the dielectric layers 12. Therefore, the elastomer piezoelectric element 10 is provided with a first region A1, in which, among the first opposite electrodes 11a and the second opposite electrodes 11b, only first opposite electrodes 11a lie over each other in a stacking direction, a second region A2, in which the first opposite electrodes 11a and the second opposite electrodes 11b lie over each other in a stacking direction, and a third region A3, in which only second opposite electrodes 11b lie over each other in a stacking direction.

Materials constituting the first opposite electrodes 11a and the second opposite electrodes 11b include conductive elastomers, carbon nanotubes, Ketjen black (registered trademark), and vapor deposited metal films. In the present embodiment, a conductive elastomer for use in a known elastomer piezoelectric element is used. Examples of such a conductive elastomer include a conductive elastomer containing insulating polymer and conductive filler.

Examples of the above-described insulating polymer include polyrotaxanes, silicone elastomers, acrylic elastomers, and urethane elastomers. One of these insulating polymers can be used alone, or two or more of these insulating polymers can be used in combination. Examples of the above-described conductive filler include Ketjen black (registered trademark), carbon black, and particles of metal such as such as copper and silver. One of these conductive fillers can be used alone, or two or more of these conductive fillers can be used in combination.

The dielectric layer 12 includes a dielectric portion 13 made of dielectric elastomer. The dielectric portion 13 is in the form of a sheet having a constant thickness. The dielectric portion 13 is formed into, for example, a thin film having a thickness of 10 to 300 µm.

The dielectric elastomer constituting the dielectric portion 13(the material of the dielectric portion 13) is not limited in particular. A dielectric elastomer for use in a known elastomer piezoelectric element can be employed. Examples of the above-described dielectric elastomer include polyrotaxanes, silicone elastomers, acrylic elastomers, and urethane elastomers. One of these dielectric elastomers can be used alone, or two or more of these dielectric elastomers can be used in combination.

A portion located at the first region A1 in the dielectric portion 13 is provided with a through-hole 14a extending through a dielectric portion 13. The diameter of the through-hole 14a is 0.5 to 5 mm. In the interior of the through-hole 14a, a conductive elastomer first common electrode 15a is disposed. The first common electrode 15a is configured by filling the interior of the through-hole 14a with a conductive elastomer. The first common electrode 15a is provided so as to extend from one main surface to the other main surface of the dielectric portion 13. The first common electrode 15a is joined to the first opposite electrode 11a through a joint surface S along the dielectric layer 12 (along a main surface of the dielectric portion 13).

The conductive elastomer constituting the first common electrode 15a (the material of the first common electrode 15a) is not limited in particular. A conductive elastomer for use in a known elastomer piezoelectric element can be employed.

A portion that is located between two dielectric layers 12 sandwiching a second opposite electrode 11b and is located at the first region A1 is provided with a conductive elastomer first auxiliary common electrode 16a. The first auxiliary common electrode 16a connects the first common electrodes 15a of the dielectric layers 12 adjacent to each other in the stacking direction. The thickness of the first auxiliary common electrode 16a is identical to the thickness of the second opposite electrode 11b. The conductive elastomer (the material of the first auxiliary common electrode 16a) constituting the first auxiliary common electrode 16a is not limited in particular. A conductive elastomer for use in a known elastomer piezoelectric element can be employed.

As described above, the first common electrode 15a joined to the first opposite electrodes 11a is provided in the dielectric layer 12, and in addition, the first auxiliary common electrode 16a connecting the first common electrodes 15a to each other is provided between two dielectric layers 12. As a result of this, the first opposite electrodes 11a are electrically connected to each other.

In the same manner as described above, a portion located at the third region A3 in the dielectric portion 13 is provided with a through-hole 14b extending through a dielectric portion 13. The diameter of the through-hole 14b is 0.5 to 5 mm. In the interior of the through-hole 14b, a conductive elastomer second common electrode 15b is disposed. The second common electrode 15b is configured by filling the interior of the through-hole 14b with a conductive elastomer. The second common electrode 15b is provided so as to extend from one main surface to the other main surface of the dielectric portion 13. The second common electrode 15b is joined to the second opposite electrode 11b through the joint surface S along the dielectric layer 12.

The conductive elastomer constituting the second common electrode 15b (the material of the second common electrode 15b) is not limited in particular. A conductive elastomer for use in a known elastomer piezoelectric element can be employed.

A portion that is located between two dielectric layers 12 sandwiching a first opposite electrode 11a and is located at the third region A3 is provided with a conductive elastomer second auxiliary common electrode 16b. The second auxiliary common electrode 16b connects the second common electrodes 15b of the dielectric layers 12, which are adjacent to each another in the stacking direction, to each other. The thickness of the second auxiliary common electrode 16b is identical to the thickness of the first opposite electrode 11a. The conductive elastomer (the material of the second auxiliary common electrode 16b) constituting the second auxiliary common electrode 16b is not limited in particular. A conductive elastomer for use in a known elastomer piezoelectric element can be employed.

As described above, the second common electrode 15b joined to the second opposite electrode 11b is provided in the dielectric layer 12, and in addition, the second auxiliary common electrode 16b connecting the second common electrodes 15b to each other is provided between two dielectric layers 12. As a result of this, the second opposite electrodes 11b are electrically connected to each other.

The remaining portion located between two dielectric layers 12 without the first opposite electrode 11a, the second opposite electrode 11b, the first auxiliary common electrode 16a, and the second auxiliary common electrode 16b being disposed is provided with an insulating elastomer insulated portion 17. The thickness of the insulated portion 17 is identical to the thickness of the first opposite electrode 11a and the second opposite electrode 11b. As the insulating elastomer constituting the insulated portion 17 (the material of the insulated portion 17), a known insulating elastomer for use in a known elastomer piezoelectric element can be employed. Examples of the above-described insulating elastomer include polyrotaxanes, silicone elastomers, acrylic elastomers, and urethane elastomers. One of these insulating elastomers can be used alone, or two or more of these insulating elastomers can be used in combination.

As shown in Fig. 1, in the elastomer piezoelectric element 10, all of the first opposite electrodes 11a are electrically connected to each other by the first common electrodes 15a and the first auxiliary common electrodes 16a. In addition, all of the second opposite electrodes 11b are electrically connected to each other by the second common electrodes 15b and the second auxiliary common electrodes 16b. The first common electrode 15a and the second common electrode 15b exposed at the outer surface of the elastomer piezoelectric element 10, that is, the first common electrode 15a and the second common electrode 15b of the dielectric layer 12 located at the top layer or the bottom layer are considered as external contacts T. As result of the above-described configuration of the elastomer piezoelectric element 10, it is possible through the external contacts T to apply identical electric potentials to all of the first opposite electrodes 11a, and in addition, apply identical electric potentials to all of the second opposite electrodes 11b.

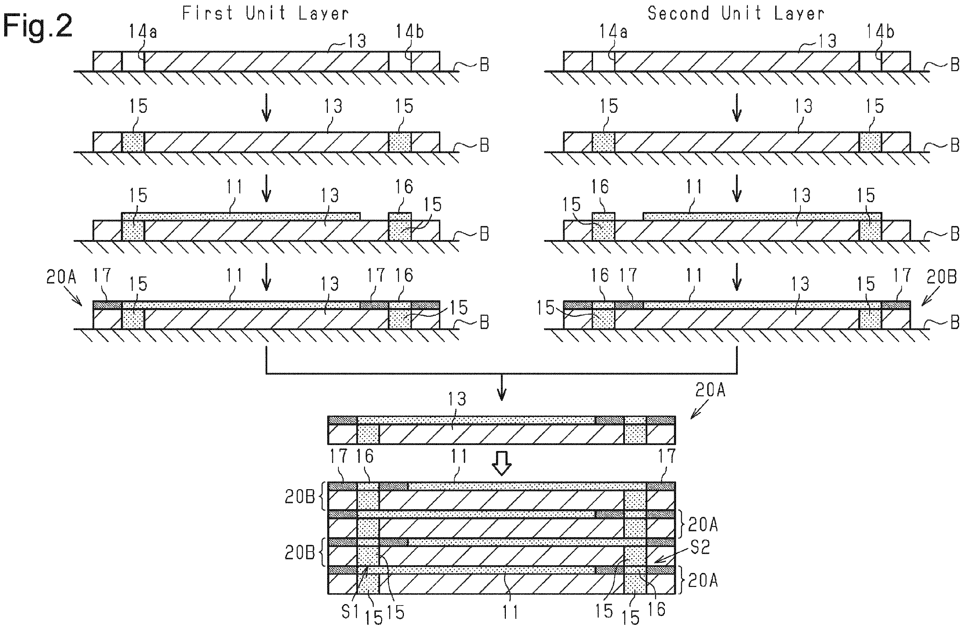

Next, a first method for producing an elastomer piezoelectric element 10 will be described with reference to Fig. 2. The elastomer piezoelectric element 10 is produced by performing a unit layer forming step and a stacking step described below in a sequential manner.

### Unit Layer Forming Step

In a unit layer forming step, a unit layer including a dielectric portion 13, a common electrode 15, and an opposite electrode 11 is formed. In the unit layer forming step, a first unit layer 20A including a first opposite electrode 11a and a second unit layer 20B including a second opposite electrode 11b are formed.

First, an apparatus such as a slit die coater is used to apply a source material composition of a dielectric elastomer having a low viscosity to the surface of an easily peelable substrate B such as a release sheet. Next, a dielectric portion 13 made of dielectric elastomer that has a constant thickness is formed by curing treatment such as heating or crosslinking. At this time, two through-holes 14a, 14b are formed in the dielectric portion 13 by using a mask having a shape corresponding to through-holes 14a, 14b, or by cutting or removing a portion of the dielectric portion 13 after curing by laser or the like. Then, a source material composition of a conductive elastomer having a low viscosity is applied to the inner side of the through-holes 14a, 14b of the dielectric portion 13. Next, two conductive elastomer common electrodes 15 are formed by curing treatment.

Next, a source material composition of a conductive elastomer having a low viscosity is applied to one main surface of the dielectric portion 13 from a position including an end face of the common electrode 15 of one of the two common electrodes 15 to a position in the vicinity of the common electrode 15 of the other one of the two common electrodes 15 (in a range corresponding to the opposite electrode 11). Next, a conductive elastomer opposite electrode 11 is formed by curing treatment. In addition, a source material composition of a conductive elastomer having a low viscosity is applied to an end face of the common electrode 15 in which the opposite electrode 11 is not formed in such a way that the thickness of the applied source material composition is identical to the thickness of the opposite electrode 11. Next, a conductive elastomer auxiliary common electrode 16 is formed by curing treatment.

Next, a source material composition of an insulating elastomer having a low viscosity is applied to a portion of a main surface of the dielectric portion 13 in which neither the opposite electrode 11 nor the auxiliary common electrode 16 is formed in such a way that the thickness of the applied source material composition is identical to the thickness of the opposite electrode 11 and the thickness of the auxiliary common electrode 16. Next, an insulating elastomer insulated portion 17 is formed by curing treatment.

The positions on a main surface of the dielectric portion 13 in the first unit layer 20A at which the opposite electrode 11, the auxiliary common electrode 16, and the insulated portion 17 have been formed are different from those in the second unit layer 20B. Examples of the method for application of the source material compositions of the dielectric elastomer, the conductive elastomer, and the insulating elastomer, and other source material compositions of the opposite electrode 11 include a method for application by ink jet printing, and a method for application by spraying or the like using masks having patterns corresponding to an opposite electrode 11, an auxiliary common electrode 16, and an insulated portion 17.

A film-shaped structure obtained by laminating the opposite electrode 11 and the auxiliary common electrode 16 on the dielectric portion 13 and the common electrode 15 is peeled away from the substrate B. As a result of this, a first unit layer 20A and a second unit layer 20B are obtained. If necessary, the resulting unit layer is subjected to compression treatment (for example, isostatic pressing under vacuum).

### Stacking Step

In the stacking step, a plurality of unit layers (a first unit layer 20A and a second unit layer 20B) obtained in the unit layer forming step are stacked and joined together.

First, a surface on the side at which the opposite electrode 11 is located in the first unit layer 20A is placed to be opposed to a surface on the side at which the opposite electrode 11 is not located in the second unit layer 20B. In this situation, the first unit layer 20A and the second unit layer 20B are pressed against each other to join the first unit layer 20A and the second unit layer 20B.

At this time, the first unit layer 20A and the second unit layer 20B are joined to form a portion in which the common electrode 15 and the opposite electrode 11 are joined together and a portion in which the common electrodes 15 are joined together through the auxiliary common electrode 16. Specifically, a portion S1 is formed, in which the opposite electrode 11 of the first unit layer 20A, and the common electrode 15 not connected to the opposite electrode 11 in the second unit layer 20B are joined together. In addition, a portion S2 is formed, in which the common electrode 15 not connected to the opposite electrode 11 in the first unit layer 20A, and the common electrode 15 connected to the opposite electrode 11 in the second unit layer 20B are joined together through the auxiliary common electrode 16.

In the same manner as described above, the above-described processes are repeatedly performed in such a way that the first unit layer 20A and the second unit layer 20B are alternately stacked. As a result of this, an elastomer piezoelectric element 10 as shown in Fig. 1 is obtained, the elastomer piezoelectric element 10 being configured by alternately disposing conductive elastomer first opposite electrodes 11a and conductive elastomer second opposite electrodes 11b, and sandwiching dielectric layers 12 each having a first common electrode 15a and a second common electrode 15b between the first opposite electrode 11a and the second opposite electrode 11b.

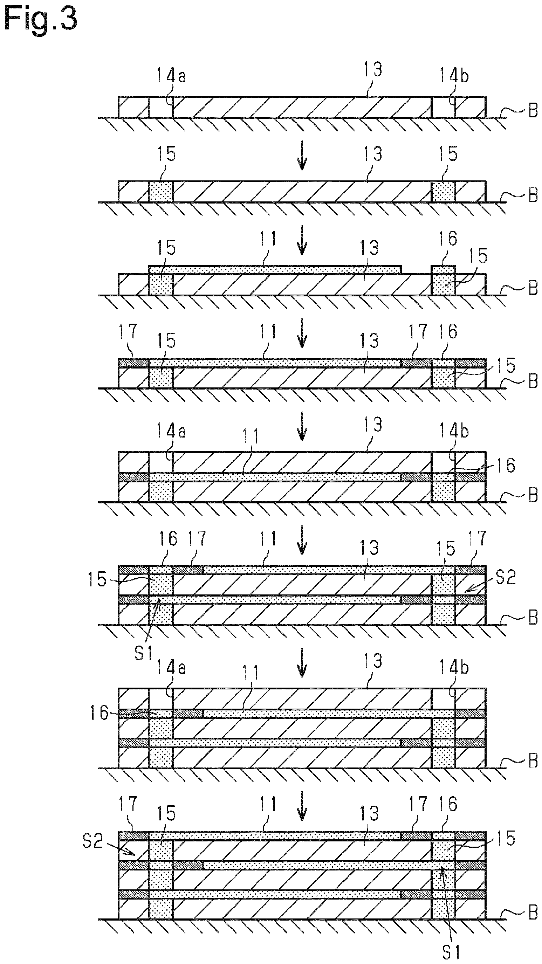

Next, a second method for producing an elastomer piezoelectric element 10 will be described with reference to Fig. 3. The elastomer piezoelectric element 10 is produced by alternately performing a dielectric portion forming step and an electrode forming step described below.

### Dielectric Portion Forming Step

An apparatus for spraying, ink jet printing or the like is used to apply a source material composition of a dielectric elastomer having a low viscosity to a surface of an easily peelable substrate B such as a release sheet. Next, a dielectric portion 13 made of dielectric elastomer that has a constant thickness is formed by curing treatment. At this time, two through-holes 14a, 14b are formed in the dielectric portion 13. In the case of application by spraying, a mask having a shape corresponding to through-holes 14a, 14b is used.

### Electrode Forming Step

A source material composition of a conductive elastomer having a low viscosity is applied to the inner side of through-holes 14a, 14b of the dielectric portion 13. Next, two conductive elastomer common electrodes 15 are formed by curing treatment. A source material composition of a conductive elastomer having a low viscosity is applied to one main surface of the dielectric portion 13 from a position including an end face of one common electrode 15 of the two common electrodes 15 to a position in the vicinity of the other common electrode 15 (in a range corresponding to the opposite electrode 11a). Next, a conductive elastomer opposite electrode 11 is formed by curing treatment. In addition, a source material composition of a conductive elastomer having a low viscosity is applied to an end face of the common electrode 15 in which the opposite electrode 11 is not formed in such a way that the thickness of the applied source material composition is identical to the thickness of the opposite electrode 11. Next, a conductive elastomer auxiliary common electrode 16 is formed by curing treatment.

Next, a source material composition of an insulating elastomer having a low viscosity is applied to a portion of a main surface of the dielectric portion 13 in which neither the opposite electrode 11 nor the auxiliary common electrode 16 is formed in such a way that the thickness of the applied source material composition is identical to the thickness of the opposite electrode 11 and the thickness of the auxiliary common electrode 16. Next, an insulating elastomer insulated portion 17 is formed by curing treatment.

### Repeating of Dielectric Portion Forming Step and Electrode Forming Step

The opposite electrode 11, the auxiliary common electrode 16, and the insulated portion 17 formed in the electrode forming step are subjected to the above-described dielectric portion forming step. As a result of this, a dielectric portion 13 made of dielectric elastomer that has two through-holes 14a, 14b is formed. At this time, the through-hole 14a is formed to be located on the opposite electrode 11. The through-hole 14b is formed to be located on the auxiliary common electrode 16 (common electrode 15).

The newly formed dielectric portion 13 is subjected to the above-described electrode forming step. As a result of this, a common electrode 15, an opposite electrode 11, an auxiliary common electrode 16, and an insulated portion 17 are formed. At this time, new two common electrodes 15 are formed in such a way that a portion S1, in which a new common electrode 15 and the opposite electrode 11 located at the underlying layer are joined together, and a portion S2, in which a new common electrode 15 and the common electrode 15 located at the underlying layer, are joined together through the auxiliary common electrode 16. Next, an opposite electrode 11 is formed on one main surface of the dielectric portion 13 from a position including an end face of the common electrode 15 not connected to the opposite electrode 11 in the underlying layer to a position in the vicinity of the other common electrode 15 (in a range corresponding to the second opposite electrode 11b). An auxiliary common electrode 16 is formed on an end face of the common electrode 15 in which the opposite electrode 11 is not formed.

In this way, the above-described dielectric portion forming step and the above-described electrode forming step are repeatedly performed while causing the formation positions of the opposite electrode 11 and the auxiliary common electrode 16 in the electrode forming step to be different from each other. As a result of this, an elastomer piezoelectric element 10 as shown in Fig. 1 is obtained, the elastomer piezoelectric element 10 being configured by alternately disposing conductive elastomer first opposite electrodes 11a and conductive elastomer second opposite electrodes 11b, and sandwiching dielectric layers 12 each having a first common electrode 15a and a second common electrode 15b between the first opposite electrodes 11a and the second opposite electrodes 11b.

The operation and advantages of the present embodiment will now be described. In the following description, the first opposite electrode 11a and the second opposite electrode 11b may be referred to collectively as opposite electrodes, the first common electrode 15a and the second common electrode 15b may be referred to collectively as auxiliary common electrodes, and the first auxiliary common electrode 16a and the second auxiliary common electrode 16b may be referred to collectively as auxiliary common electrodes.
(1) The elastomer piezoelectric element 10 is configured by alternately disposing conductive elastomer first opposite electrodes 11a and conductive elastomer second opposite electrodes 11b, and sandwiching a dielectric layer 12 between each first opposite electrode 11a and the corresponding second opposite electrode 11b. The dielectric layer 12 includes a dielectric elastomer sheet-shaped dielectric portion 13, a conductive elastomer first common electrode 15a, and a conductive elastomer second common electrode 15b. The first common electrode 15a connects the first opposite electrodes 11a to each other. The second common electrode 15b connects the second opposite electrodes 11b to each other. The first common electrode 15a and the second common electrode 15b are provided to extend from one main surface to the other main surface of the dielectric portion 13. The first common electrode 15a is connected to the first opposite electrode 11a through the joint surface S along the dielectric layer 12. The second common electrode 15b is connected to the second opposite electrode 11b through the joint surface S along the dielectric layer 12.
   According to the above-described configuration, the common electrode electrically connecting the first opposite electrodes 11a to each other and the common electrode electrically connecting the second opposite electrodes 11b to each other are each provided as a portion of the dielectric layer 12. In this case, the joint surface S of the opposite electrode and the common electrode is located between the dielectric layer 12 and the opposite electrode. This ensures a broader joint surface S than that in the case where the common electrode is joined to an edge (end face) of the opposite electrode. As a result of this, the opposite electrode and the common electrode are tightly joined together to improve the durability of the elastomer piezoelectric element 10 against the displacement of the dielectric layer 12.
   The above-described configuration joins the opposite electrode and the common electrode together in the vicinity of a displaced portion of the dielectric layer 12, that is, a portion sandwiched between the first opposite electrode 11a and the second opposite electrode 11b. Therefore, when compared to the case where the opposite electrode and the common electrode are joined together at an edge (end face) of the opposite electrode, the elastomer piezoelectric element 10 can be downsized.
(2) The common electrodes are provided in the interior of the through-holes 14a, 14b provided in the dielectric portion 13.
   The above-described configuration covers the joint portion of the opposite electrode and the common electrode with the dielectric portion 13 made of dielectric elastomer. As a result of this, when external force is exerted on the elastomer piezoelectric element 10, the impact of the external force is unlikely to reach the above-described joint portion. Accordingly, the durability of the elastomer piezoelectric element 10 is improved.
(3) An insulating elastomer insulated portion 17 is disposed on a portion which is located between two dielectric layers 12 and in which the opposite electrode is not disposed.
   The above-described configuration provides the insulated portion 17, so that an air layer tends not to be formed in the area surrounding the opposite electrode between two dielectric layers 12. This prevents creeping discharge from being caused by formation of an air layer, and prevents dielectric breakdown from occurring due to creeping discharge.
   As a method for eliminating the above-described air layer, the dielectric portions 13 of adjacent dielectric layers 12 may be pressed in the stacking direction in such a way that the dielectric portions 13 are in contact with each other during the production of an elastomer piezoelectric element 10. In this case, however, part of the dielectric portion 13 flows into the area surrounding the opposite electrode 11 to reduce the thickness of the dielectric portion 13 partially. As a result of this, dielectric breakdown in the portion having thus reduced thickness tends to occur. In contrast, when the above-described configuration is employed, such a problem is avoided.
(5) The method for producing the elastomer piezoelectric element 10 includes a unit layer forming step of forming a unit layer and a stacking step of stacking and joining a plurality of unit layers together. The unit layer includes a dielectric elastomer sheet-shaped dielectric portion 13, two conductive elastomer common electrodes 15, and a conductive elastomer opposite electrode 11. The common electrode 15 is provided so as to extend from one main surface to the other main surface of the dielectric portion 13. The opposite electrode 11 is disposed on one main surface of the dielectric portion 13 to be connected to the common electrode 15. In the stacking step, a portion S1, in which the common electrode 15 and the opposite electrode 11 are joined together, and a portion S2, in which the common electrodes are joined to each other (through the auxiliary common electrode), are formed. As a result of this, specific opposite electrodes are electrically connected to each other.
   The above-described configuration provides an elastomer piezoelectric element 10 that includes a common electrode connected to an opposite electrode on a broad joint surface S.
   In addition, when a stacked body of the opposite electrode and the dielectric portion 13 is formed, the structure obtained by connecting specific opposite electrodes to each other through the common electrode is also formed. Therefore, the elastomer piezoelectric element 10 does not need to include a common electrode that connects the specific opposite electrodes to each other.
(6) The method for producing the elastomer piezoelectric element 10 includes repeatedly performing the dielectric portion forming step and the electrode forming step. In the dielectric portion forming step, a dielectric elastomer sheet-shaped dielectric portion 13 is formed. In the electrode forming step, two conductive elastomer common electrodes extending from one main surface to the other main surface of the dielectric portion 13 are formed, and in addition, a conductive elastomer opposite electrode connected to one of the two common electrode is formed on one main surface of the dielectric portion 13. The dielectric portion forming step and the electrode forming step are repeatedly performed to stack dielectric portions 13 and opposite electrodes alternately. In the electrode forming step, when new two common electrodes are formed, a portion S1, in which a new common electrode and the opposite electrode located at the underlying layer are joined together, and a portion S2, in which a new common electrode and the common electrode located at the underlying layer, are joined together (through an auxiliary common electrode) are formed. As a result of this, specific opposite electrodes are electrically connected to each other.

The above-described configuration provides an elastomer piezoelectric element 10 that includes a common electrode connected to an opposite electrode 11 on broad joint surfaces S.

In addition, when the opposite electrode and the dielectric portion 13 are formed by sequential stacking, a structure obtained by connecting specific opposite electrodes through the common electrode is also formed. Therefore, the elastomer piezoelectric element 10 does not need to include a common electrode connecting specific opposite electrodes to each other. In addition, since the formation and the adhesion of the opposite electrode and the dielectric portion are simultaneously performed, there is no need for performing special joining treatment such as activating and joining these surfaces together.

The above-described embodiment may be modified as follows.

The arrangement of the common electrodes in the dielectric layer 12 may be changed within the range of the first region A1 or the third region A3. For example, in each of the dielectric layers 12, the arrangement of the common electrodes may be different.

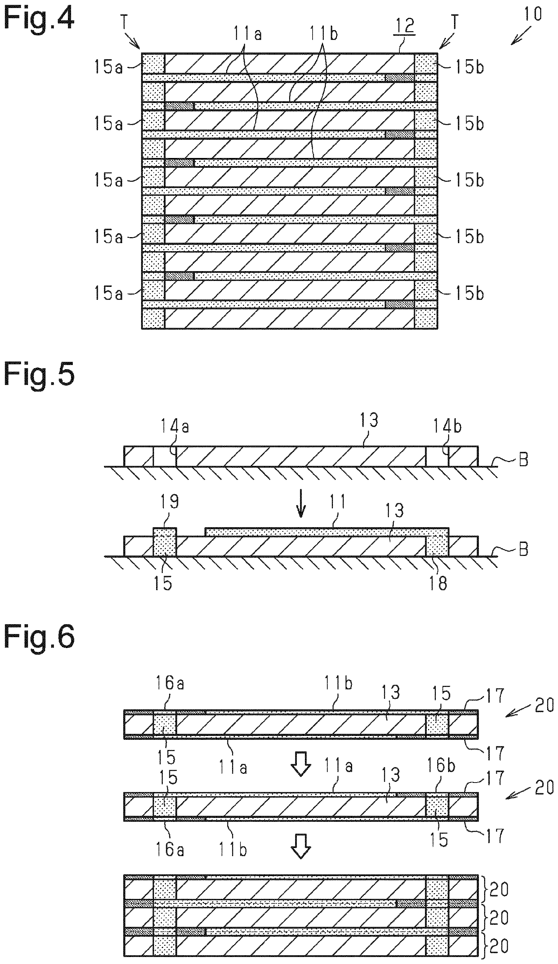

As shown in Fig. 4, the first common electrodes 15a and the second common electrodes 15b may be disposed at the edges of the dielectric portion 13. In this case, the common electrode is exposed at the periphery of the dielectric layer 12, that is, at the periphery of the elastomer piezoelectric element 10. Therefore, the external contacts T can be located at the periphery of the elastomer piezoelectric element 10. This simplifies the external configuration for applying electric potentials to the elastomer piezoelectric element 10. The common electrode disposed at the interior of the dielectric portion 13 and the common electrode 15 disposed at the edge of the dielectric portion 13 may be present in a mixed manner.

The common electrode may be provided as a portion of the opposite electrode. In addition, the auxiliary common electrode may be provided as a portion of the common electrode.

For example, as shown in Fig. 5, a dielectric portion 13 having through-holes 14a, 14b is formed on a surface of the substrate B. A source material composition of a conductive elastomer having a low viscosity is applied to the inner side of the through-hole 14b and one main surface of the dielectric portion 13. Next, a conductive elastomer opposite electrode 11 is formed by curing treatment. In this case, an opposite electrode 11 having a protrusion 18 protruding into the through-hole 14b is formed. This protrusion 18 of the opposite electrode 11 can be employed as the common electrode. The above-described configuration reduces the joint portion between the opposite electrode and the common electrode.

After the dielectric portion 13 is formed, the interior of the through-hole 14a is filled with a source material composition of a conductive elastomer having a low viscosity. Next, a conductive elastomer common electrode 15 is formed by curing treatment. At this time, a common electrode 15 is provided with a protrusion 19 protruding from a main surface of the dielectric portion 13. In this case, the protrusion 19 of the common electrode 15 can be used as an auxiliary common electrode. The above-described configuration reduces the joint portion between the common electrode and the auxiliary common electrode.

In the above-described embodiment, the common electrode of the upper dielectric layer 12 and the common electrode of the lower dielectric layer 12 are joined together through the auxiliary common electrode. However, the auxiliary common electrode may be eliminated, and the common electrodes may be directly joined to each other. Therefore, the above-described portion S2 may be a portion in which the common electrodes are joined to each other through the auxiliary common electrode, or may be a portion in which the common electrodes are directly joined to each other.

The range in which the insulated portion 17 is provided between two dielectric layers 12 is not limited in particular. A portion in which the insulated portion 17 is not disposed can also be present. The insulated portion 17 may be eliminated.

In the first production method, the configuration of the unit layer is not limited to the configuration according to the above-described embodiment. For example, as shown in Fig. 6, a unit layer 20 may be configured by a dielectric portion 13, a first opposite electrode 11a, a second auxiliary common electrode 16b, and an insulated portion 17 that are disposed on one main surface of the dielectric portion 13, a second opposite electrode 11b, a first auxiliary common electrode 16a, and an insulated portion 17 that are disposed on the main surface located at the side opposite to the dielectric portion 13. In this case, in the stacking step, the unit layers 20 are stacked and joined together in such a way that the first opposite electrodes 11a, the second opposite electrodes 11b, the first auxiliary common electrodes 16a, and the second auxiliary common electrodes 16b of two unit layers 20 lie over one another. In this case, a joint surface between the unit layers 20 is not located at the dielectric portion 13. Therefore, adhesive can be used to join the unit layers 20 to each other.

### Description of the Reference Numerals

S... Joint Surface; 10... Elastomer Piezoelectric Element; 11... Opposite Electrode; 11a... First Opposite Electrode; 11b... Second Opposite Electrode; 12... Dielectric Layer; 13... Dielectric Portion; 14a,14b...Through-Holes; 15... Common Electrode; 15a... First Common Electrode; 15b... Second Common Electrode; 16... Auxiliary Common Electrode; 16a... First Auxiliary Common Electrode; 16b... Second Auxiliary Common Electrode; 17... Insulated Portion; 18,19... Protrusions; 20... Unit Layer; 20A... First Unit Layer; 20B... Second Unit Layer.

## Claims

1. An elastomer piezoelectric element configured by alternately disposing first opposite electrodes and second opposite electrodes, and sandwiching a dielectric layer between each first opposite electrode and the corresponding second opposite electrode, the elastomer piezoelectric element being **characterized in that**
each of the dielectric layers includes
a dielectric elastomer sheet-shaped dielectric portion, and
a conductive elastomer common electrode connecting the first opposite electrodes to each other or connecting the second opposite electrodes to each other, and
the common electrode is provided so as to extend from one main surface to another main surface of the dielectric portion, and is joined to the first opposite electrode or the second opposite electrode on a joint surface along the dielectric layer.

2. The elastomer piezoelectric element according to claim 1, **characterized in that** the common electrode is provided in an interior of a through-hole provided in the dielectric portion.

3. The elastomer piezoelectric element according to claim 1, **characterized in that** the common electrode is provided at an edge of the dielectric portion.

4. The elastomer piezoelectric element according to claim 1 or 2, **characterized in that** the common electrode is a protrusion formed by protruding a portion of the conductive elastomer first opposite electrode or the conductive elastomer second opposite electrode in a thickness direction of the dielectric portion.

5. The elastomer piezoelectric element according to any one of claims 1 to 4, **characterized in that** an insulating elastomer insulated portion is disposed on a portion that is located between two of the dielectric layers and on which neither the first opposite electrode nor the second opposite electrode is disposed.

6. A method for producing an elastomer piezoelectric element, being **characterized by**:
a unit layer forming step of forming a unit layer that includes
a dielectric elastomer sheet-shaped dielectric portion,
two conductive elastomer common electrodes extending from one main surface to another main surface of the dielectric portion, and
an opposite electrode disposed on one of the main surfaces of the dielectric portion and connected to one of the two common electrodes ; and
a stacking step of stacking and joining a plurality of the unit layers together,
wherein, in the stacking step, a portion in which the common electrode and the opposite electrode are joined together and a portion in which the common electrodes are joined to each other are formed, so that specific ones of the opposite electrodes are connected to each other.

7. A method for producing an elastomer piezoelectric element, being **characterized by**:
stacking dielectric elastomer sheet-shaped dielectric portions and opposite electrodes alternately by repeatedly performing
a dielectric portion forming step of forming the dielectric portion, and
an electrode forming step of forming two conductive elastomer common electrodes extending from one main surface to another main surface of the dielectric portion, and forming, on one of the main surfaces of the dielectric portion, an opposite electrode connected to one of the two common electrodes; and
connecting specific ones of the opposite electrodes to each other by, when newly forming two of the common electrodes in the electrode forming step, forming a portion in which the new common electrode and the opposite electrode located at an underlying layer are joined together and a portion in which the new common electrode and the common electrode located at an underlying layer are joined together.
